**Europäisches Patentamt**

**European Patent Office**

**Office européen des brevets**

(11) Publication number: **0 043 480**
**B1**

## (12) EUROPEAN PATENT SPECIFICATION

(45) Date of publication of patent specification: **03.04.85**

(21) Application number: **81104764.6**

(22) Date of filing: **22.06.81**

(51) Int. Cl.⁴: **G 03 C 1/72, G 03 F 7/10, G 03 C 5/00**

(54) Process for forming metallic images.

(30) Priority: **25.06.80 JP 85099/80**
**25.06.80 JP 85100/80**

(43) Date of publication of application:
**13.01.82 Bulletin 82/02**

(45) Publication of the grant of the patent:
**03.04.85 Bulletin 85/14**

(84) Designated Contracting States:
**DE FR**

(56) References cited:
**DE-A-2 255 118**
**FR-A-2 359 431**
**US-A-4 019 904**

**PATENTS ABSTRACTS OF JAPAN, vol. 4, no. 110 (P-22) (592), 8th August 1980, page 83P22, Japanese Patent Office, Tokyo, JP**

(73) Proprietor: **Hitachi, Ltd.**
**5-1, Marunouchi 1-chome**
**Chiyoda-ku Tokyo 100 (JP)**

(72) Inventor: **Sakurai, Hideki**
**4-28, Nakayama-3-chome**
**Sendai-shi (JP)**
Inventor: **Nakatani, Mitsuo**
**201, Akibacho**
**Totsuka-ku Yokohama (JP)**
Inventor: **Oka, Hitoshi**
**241-99, Fukayacho**
**Totsuka-ku Yokohama (JP)**
Inventor: **Yokono, Hitoshi**
**1167, Shimokuratacho**
**Totsuka-ku Yokohama (JP)**
Inventor: **Isogai, Tokio**
**3941-1, Fujisawa**
**Fujisawa-shi (JP)**

(74) Representative: **Patentanwälte Beetz sen. - Beetz jun. Timpe - Siegfried - Schmitt-Fumian et al**
**Steinsdorfstrasse 10**
**D-8000 München 22 (DE)**

Courier Press, Leamington Spa, England.

**0 043 480**

## Description

This invention relates to a process for optically forming metallic images on substrates.

For optically forming a metallic image on the surface of a substrate such as plastics, ceramics or the like, there is known the so-called negative type process by wich a metallic image is formed on the exposed part of a photosensitive material. However, e.g. for forming a circuit pattern of a printed circuit board having through-holes by the additive method with use of a negative type material, it is necessary to expose the photosensitive material layer also on the through-hole wall surface for the sake of producing plating nuclei. Nevertheless, it is quite difficult to expose with certainty all the photosensitive material on the wall surfaces of a plurality of through-holes, because the through-holes usually have a small diameter and their wall surfaces are rough.

In contrast thereto, if a positive type material is used, the unexposed regions cause nucleation for the subsequent plating, so that plating occurs with certainty also on the through-hole wall surfaces. For example, a metallic image can be formed on a substrate by coating it with a positive type material containing a salt of metal ion the oxidation state of which changes upon irradiation with ultraviolet rays ($Sn^{3+}$, $Ti^{3+}$, $Pb^{3+}$ or the like), selectively exposing it to light the unexposed portions being capable for nucleation, and then dipping it into a chemical metal plating solution to deposit the metal on said unexposed portions.

However, the above-mentioned positive type process is disadvantageous in that the metal salt applied to the positive type photosensitive material is so unstable that the resulting copper circuit is not of uniform quality and therefore the product yield is low.

It is an object of this invention to provide a process for forming metallic images by the use of a positive type photosensitive material by which the above-mentioned faults of prior techniques can be overcome and metallic images of uniform quality can be formed in a high yield.

The above underlying problem is solved according to claim 1. The subclaims refer to preferred embodiments.

The process according to the invention for forming metallic images on a substrate comprises the steps of:

— coating a solution of a photosensitive material onto a surface of the substrate,
— drying the photosensitive material,
— irradiating the dried coating of photosensitive material with ultraviolet radiation, electron beams or ion beams through a photo-mask and,
— contacting the resulting substrate with a solution of a metal salt plating solution to deposit metal particles on the unexposed portions,

and is characterised in that there are used;
(A) as the photosensitive material, either
(a) at least one organic compound having in the molecule at least one linkage of the formula —M—M-(-M-)$_n$, wherein M is an atom of Si, Ge or Sn, and n is zero or an integer of 1 to 10, or
(b) at least one organic compound (a) in admixture with at least one photosensitizer selected from nitrofluorene and derivatives thereof, benzophenone and derivatives thereof, acetophenone and derivatives thereof, benzil and derivatives thereof and benzoin and derivatives thereof, and
(B) as solvent for the photosensitive material halogenated hydrocarbons, aromatic hydrocarbons, heterocyclic compounds, or mixtures thereof and that when ultraviolet radiation is used to indicate the dried coating of photosensitive material it has a wavelength of 300 nm or less in the case of A(a) and a wavelength within the whole wavelength range in the case of A(b).

The organic compounds according to above (A)(a) are designated hereinafter as polymetal compounds.

Accordingly, the irradiation is effected with ultraviolet rays having a wavelength of 300 nm or less when the photosensitive material does not comprise a photosensitizer according to above (A) (a), whereas ultraviolet rays covering the whole wavelength range can be used when the photosensitive material contains a photosensitizer according to above (A) (b).

The polymetal compounds as used according to the invention have the following characteristic properties:

(i) Upon contact with metal ions such as of Ag, Pd, Pt, Hg, Cu, Ni, etc., they reduce the metal ions and deposit metal particles.
(ii) When the —M—M-(-M-)$_n$ linkage in the compounds is cloven, they lose the ability to reduce metallic ions.
(iii) The —M—M-(-M-)$_n$ linkage in the compounds is easily cloven by irradiation with ultraviolet rays having a wavelength shorter than 300 nm, electron beams or ion beams.

The mixtures belonging to the above-mentioned feature (A) (b) have the following characteristic property (iv) in addition to the above-mentioned properties (i) and (ii).

2

(iv) The —M—M—(M—)$_n$ linkage of the polymetal compound in said mixtures is easily cloven by irradiation with ultraviolet rays having not only a wavelength shorter than 300 nm but also a wavelength of 300 nm or longer, electron beams or ion beams.

Accordingly, metallic images can be formed on a substrate by applying a solution of the polymetal compound in an organic solvent onto the surface of the substrate including the wall surface of through-holes, drying the solution, irradiating the coated substrate with ultraviolet rays having a wavelength of 300 nm or less and preferably a wavelength of 300—50 nm, electron beams or ion beams through a photo-mask, and then contacting the substrate with a solution of a metal salt such as a silver salt to deposit particles of metal such as silver on the unexposed parts.

If a photosensitizer is used together with the polymetal compound in the photosensitive material the selective exposure is carried out with ultraviolet rays having a wavelength within the whole wavelength range and preferably having a wavelength of 320—500 nm, electron beams or ion beams. The exposure may be carried out at a wavelength longer than 300 nm in this case, because the photosensitizer is used.

As photo-masks, those made of inexpensive glass or on the basis of organic films can be used.

When said photosensitizer is used, the sensitivity is better than in the case of using no photosensitizer even if the irradiation is carried out at a short-wavelength of 300 nm or less.

The substrates are electrically insulating boards made from epoxy resin, phenolic resin, polyimide resin or the like; fiber reinforced boards produced by reinforcing these resins with glass fibers or the like, laminated boards produced by laminating glass cloth or the like and impregnating with these resins; or ceramic plates, glass plates, plates of alumina and the like.

Examples of said polymetal compounds are the following:

1,2-dimethyldisilane, 1,1,1-trichlorotrimethyldisilane, penta-methyldisilanyl cyanide, hexaphenyl-disilane, ethoxypentamethyldisilane, octamethyl-1,4-dioxa-2,3,5,6-tetrasilacyclohexane, bis(pentamethyl-disilanyl)ether, tetramethyl-1,2-bis(pentamethyldisilanoxy)disilane, 1,1'-bis(pentamethyldisilanyl)ferro-cene, bis(pentaethyldisilanyl)mercury, 1,2,2,3-tetramethyltetraphenyltrisilane, octaphenyltrisilane, octamethyl-1,4-diphenyltetrasilane, tris(dimethylphenylsilyl)silane, octamethyl-2,2,4,4-tetraphenylpentasilane, 1,5-bis(allyloxy)decaphenylpentasilane, 1,6-dichlorododecamethylhexasilane, 1,1-dimethyldecaphenyl-cyclohexasilane, hexadecamethylheptasilane, dodecamethyl-1,1,1,8,8,8-hexaphenyloctasilane, dodecamethyl-1,1,1,2,2,9,9,10,10,10-decaphenyldecasilane, tetrabromo-1,2-diphenyldigermane, 1,2-diethyltetra-phenyl-digermane, hexaphenyldigermane, octaphenyltrigermane, tris(triphenylgermyl)germane, decaphenylcyclopentagermane, 1,2-dichlorotetramethylditin, 1,1,1-trimethyltriphenylditin, 1,2-bis(trichloro-acetoxy)tetraphenylditin, hexaphenylditin, hexa-2-biphenylditin, 1,3-dichlorohexa-n-propyltritin, 1,4-dichlorooctaethyltetratin, octa-tert-butylcyclotetratin, octabenzylcyclotetratin, tetrakis(triphenyl-stannyl)tin, dodecaphenylcyclohexatin and dodeca-β-naphthylcyclohexatin.

Examples of said photosensitizer are the following: 2-nitrofluorene, 2,4,7-trinitrofluorene, 2,4,5,7-tetranitrofluorene, benzophenone, 4-methoxybenzophenone, 4,4'-dimethoxybenzophenone, 3-methoxybenzophenone, 4,4'-dibromobenzophenone, 4,4'-dichlorobenzophenone, 3-chlorobenzophenone, 4-cyanobenzophenone, 2,4-dimethylbenzophenone, 4-phenylbenzophenone, 4,4'-bis(dimethylamino)benzophenone, acetophenone, 3-cyanoacetophenone, 4-methylacetophenone, 3-bromoacetophenone, 2,4,6-trimethylacetophenone, 4-chloroacetophenone, 4-methoxyacetophenone, 4-phenylacetophenone, benzil, 4,4'-dimethoxybenzil, 4,4'-dibromobenzil, benzoin, benzoin methyl ether, benzoin ethyl ether, benzoin isopropyl ether and benzoin acetate.

Said photosensitizer is blended into said polymetal compound preferably in a proportion of at least one molecule of photosensitizer per one —M—M—(M—)$_n$ linkage in the polymetal compound.

Said polymetal compound or mixtures of said polymetal compound and said photosensitizer can be coated onto the substrate by dissolving them into the organic solvent according to (B) and applying the solution by a usual method such as a dipping, spin coating, spraying or the like. For improving the coating properties of photosensitive material and its adhesion to the substrate, a polymer such as a butadiene resin, epoxy resin, polyester resin and the like can be further added to the photosensitive material.

As the solvent, there can be used according to (B) halogenated hydrocarbons such as 1,2-dichloroethane, 1,1,2-trichloroethane, carbon tetrachloride and the like, aromatic hydrocarbons such as benzene and benzene derivatives, e.g., dichlorobenzene, and the like, heterocyclic compounds such as tetrahydrofuran and the like and mixtures thereof.

The coating film formed on the substrate is optionally heated by a usual method for drying.

The selective exposure of the photosensitive coating comprising the polymetal compound, optionally mixed with the photosensitizer, formed on the substrate is carried out by irradiating it through a photo-mask with ultraviolet rays, generated by a Xe-Hg lamp, a chemical lamp, a high pressure mercury lamp or the like, or with electron or ion beams.

For depositing metal particles and forming a metallic image on the selectively unexposed parts of the substrate a metal salt solution is applied by dipping, spraying or the like. This solution is prepared by dissolving an inorganic salt, an organic acid salt or a complex salt of Ag, Pd, Pt, Au, Hg, Ni, Cu or the like in water, an organic solvent such as ethanol or their mixtures. If necessary, the solution can further contain a stabilizer, a reducing aid for metal ions and other additives. The deposition of the metal particles can be accelerated by elevating the temperature of the solution.

**0 043 480**

The metallic image thus formed is washed with water, an organic solvent or the like and then dried. Hereunder, this invention will be explained with reference to examples.

Example 1

A photosensitive solution A of the following composition containing a polymetal compound was prepared:

Photosensitive solution A

| | parts b.w. |
|---|---|
| Hexaphenyldisilane | 0,1 |
| 1,2-Dichloroethane | 99,9 |

By the use of a drill, through-holes of 1 mm diameter were bored through a glass-epoxy substrate with a pitch of 3 mm. The substrate was then washed with water and with isopropanol and dried at 80°C for 10 min, after which the substrate was dipped into the photosensitive solution A, pulled out at a speed of 10 cm/min and dried at 50°C for 10 min to form a coating film of hexaphenyldisilane on the substrate surface including the through-hole wall surfaces. Then, the substrate was exposed to ultraviolet rays by means of a He-Hg lamp at a wavelength of 254 nm with an intensity of 10 mW/cm² for 5 min through a photo-mask consisting of a chromium film as light-screening part formed on a quartz base. Then, the exposed substrate was dipped into a 1% (by weight) ethanolic solution of AgClO₄ for 1 min, pulled out, washed with hot water of 40°C and dried at 80°C for 10 min.

As a result, a clear pattern of Ag metal particles was formed on the unexposed parts of the substrate in conformity to the photo-mask pattern. The Ag metal particles were uniformly deposited also on the through-hole wall surfaces which were not exposed to light.

Subsequently, the substrate was dipped into an electroless copper plating solution for 3 h and then washed with water and dried at 80°C for 10 min. As a result, copper was deposited only on the previously formed Ag metal particle pattern and no deposition of copper occurred on other parts. Further, the copper was deposited uniformly also on the wall surfaces of the through-holes.

Example 2

A photosensitive solution B of the following composition containing a polymetal compound was prepared:

Photosensitive solution B

| | parts b.w. |
|---|---|
| Bis(pentamethyldisilanyl)ether | 0,1 |
| 1,2-Dichloroethane | 99,9 |
| Butadiene-acrylonitrile copolymer resin | 0,5 |

In the same manner as in Example 1, the photosensitive solution B was coated onto a glass epoxy substrate having through-holes and exposed to the light. Then it was dipped into a 1% (by weight) aqueous solution of PdCl₂ for 1 min, pulled out, washed with water and dried at 80°C for 10 min. As a result, a Pd metal particle pattern was formed with high accuracy on the unexposed parts of the substrate in conformity with the photo-mask pattern. The Pd metal particles were deposited uniformly also on the wall surfaces of the through-holes which were not exposed to light.

Subsequently, the substrate was dipped into an electroless copper plating solution in the same manner as in Example 1. As a result, copper was deposited uniformly only on those parts on which Pd metal particles had been deposited.

Example 3

A photosensitive solution C of the following composition containing a polymetal compound was prepared:

Photosensitive solution C

| | parts b.w. |
|---|---|
| 1,6-Dichlorododecamethylhexasilane | 0,1 |
| 1,2-Dichloroethane | 99,9 |

In the same manner as in Example 1, through-holes were bored through a paper-phenolic resin substrate and the substrate was washed, dried and coated with the photosensitive solution C. Then it was exposed to light and dipped into the metal salt solution in the same manner as in Example 1. As a result, Ag

4

metal particles were uniformly deposited only on the unexposed parts. Subsequently, it was dipped into an electroless copper plating solution in the same manner as in Example 1. As a result, copper was deposited uniformly only on those parts on which Ag metal particles had been deposited.

Example 4

A photosensitive solution D of the following composition containing a polymetal compound was prepared:

Photosensitive solution D

|  | parts b.w. |
|---|---|
| 1,1-Dimethyldecaphenylcyclohexasilane | 0,1 |
| 1,2-Dichloroethane | 99,9 |

In the same manner as in Example 1, a 96% alumina substrate was coated with the photosensitive solution D, exposed to light and dipped into the metal salt solution. As a result, Ag metal particles were uniformly deposited only on the unexposed parts. Subsequently, the substrate was dipped into an electroless copper plating solution in the same manner as in Example 1. As a result, copper was uniformly deposited only on those parts on which Ag metal particles had been deposited.

Example 5

A photosensitive solution E of the following composition containing a polymetal compound was prepared:

Photosensitive solution E

|  | parts b.w. |
|---|---|
| Tetrabromo-1,2-diphenyldigermane | 0,1 |
| 1,2-Dichloroethane | 99,9 |

A glass epoxy substrate prepared in the same manner as in Example 1, was coated with the photosensitive solution E, exposed to light and dipped into the metal salt solution in the same manner as in Example 1. As a result, Ag metal particles were uniformly deposited only on the unexposed parts.

Subsequently, the substrate was dipped into an electroless plating solution in the same manner as in Example 1. As a result, copper was uniformly deposited only on those parts on which Ag metal particles had been deposited.

Example 6

A photosensitive solution F of the following composition containing a polymetal compound was prepared:

Photosensitive solution F

|  | parts b.w. |
|---|---|
| Decaphenylcyclopentagermane | 0,1 |
| 1,2-Dichloroethane | 99,9 |
| Butadiene-acrylonitrile copolymer resin | 0,25 |

A glass substrate having a roughened surface was coated with the photosensitive solution F, exposed to light and dipped into the metallic salt solution in the same manner as in Example 1. As a result, Ag metal particles were uniformly deposited only on the unexposed parts.

Example 7

A photosensitive solution G of the following composition containing a polymetal compound was prepared:

Photosensitive solution G

|  | parts b.w. |
|---|---|
| Hexaphenylditin | 0,1 |
| 1,2-Dichloroethane | 99,9 |

A glass epoxy substrate prepared in the same manner as in Example 1 was coated with the photosensitive solution G, exposed to light and dipped into the metal salt solution in the same manner as in Example 1. As a result, Ag metal particles were uniformly deposited only on the unexposed parts. Subsequently, this substrate was dipped into an electroless copper plating solution in the same manner as in Example 1. As a result, copper was uniformly deposited only on those parts on which Ag metal particles had been deposited.

Example 8

A photosensitive solution H of the following composition containing a polymetal compound was prepared:

Photosensitive solution H

|  | parts b.w. |
|---|---|
| 1,4-Dichlorooctaethyltetratin | 0,1 |
| 1,2-Dichloroethane | 99,9 |

A glass epoxy substrate prepared in the same manner as in Example 1 was coated with the photosensitive solution H, exposed to the light and dipped into the metal salt solution in the same manner as in Example 1. As a result, Ag metal particles were deposited only on the unexposed parts. Subsequently, this substrate was dipped into an electroless copper plating solution in the same manner as in Example 1. As a result, copper was deposited uniformly only on those parts on which Ag metal particles had been deposited.

Example 9

In this example different photosensitizers were used (experiments 1 to 14). In all cases a phenolic resin laminate board was dipped into a photosensitive solution which comprised 0,1 mole of hexaphenylditin (polymetal compound), 0,15 mole of the respective photosensitizer and 1,2-dichloroethane (solvent). Then it was pulled out at a speed of 50 cm/min and dried at 50°C for 5 min. This substrate was closely contacted with a photomask made of soda glass and exposed to ultraviolet rays for 10 min with a Xe-Hg lamp at a wavelength of 365 nm and an intensity of 14,3 mW/cm$^2$. Then it was dipped into a 1% (by weight) ethanolic solution of AgClO$_4$ for 1 min, pulled out, washed with hot water of 40°C and dried at 80°C for 5 min. The results obtained are listed in the table. It may be seen from the experiments 1 to 14 of the table, that Ag particles giving the metallic image were deposited only on the parts screened by the photo-mask, and no deposition of Ag particles was noticeable in the exposed parts.

| Experiment | Composition of photosensitive solution | | | Ag image pattern |
|---|---|---|---|---|
| | Polymetal compound (0.1 mole) | Photosensitizer (0.15 mole) | Solvent (70 moles) | |
| 1 | | 2-Nitrofluorene | | Formed |
| 2 | | 2,4,7-Trinitrofluorene | | Formed |
| 3 | | Benzophenone | | Formed |
| 4 | | 4,4'-Dimethoxybenzophenone | | Formed |
| 5 | | 4,4'-Bis(dimethylamino)benzophenone | | Formed |
| 6 | | Acetophenone | | Formed |
| 7 | $(C_6H_5)_6Sn_2$ | 3-Bromoacetophenone | $CH_2ClCH_2Cl$ | Formed |
| 8 | | Benzil | | Formed |
| 9 | | 4,4'-Dimethoxybenzil | | Formed |
| 10 | | Benzoin | | Formed |
| 11 | | Benzoin methyl ether | | Formed |
| 12 | | Benzoin ethyl ether | | Formed |
| 13 | | Benzoin isopropyl ether | | Formed |
| 14 | | Benzoin acetate | | Formed |

Example 10

14 different photosensitive solutions were prepared by dissolving 0,1 mole of 1,6-dichlorododecamethylhexasilane (polymetal compound) and 0,5 mole of each of the photosensitizers shown in the experiments No. 1 to 14 of the table in 70 moles of 1,2-dichloroethane (solvent). Coating of these photosensitive solutions onto substrates, exposure to light and dipping into AgClO$_4$ solutions were carried out in the same manner as in Example 9, after which the formation of Ag particle images was examined. As a result, the formation of Ag particle image patterns was possible in all cases like in Example 9.

Example 11

14 different photosensitive solutions were prepared by dissolving 0,1 mole of tetrabromo-1,2-diphenyldigermane (polymetal compound) and 0,1 mole of each of the photosensitizers shown in the experiments Nr. 1 to 14 of the table in 70 moles of 1,2-dichloroethane (solvent). Coating of these photosensitive solutions onto substrates, exposure to light and dipping into AgClO$_4$ solution were carried out in the same manner as in Example 9, after which the formation of Ag particle images was examined. As a result, the formation of Ag particle image patterns was possible in all cases like in Example 9.

Example 12

A photosensitive solution was prepared by dissolving 0,1 mole of hexaphenylditin (polymetal compound) and 0,2 mole of benzoin ethyl ether (photosensitizer) in 70 moles of 1,2-dichloroethane (solvent). This photosensitive solution was coated onto a glass epoxy substrate having a thickness of 0,6 mm by means of a spinner at a rotation speed of 300 min$^{-1}$; subsequently a quartz base photo-mask was closely contacted. It was irradiated with ultraviolet rays for 120 s by the use of the same lamp as in Example 10 and then dipped into the AgClO$_4$ solution, whereby Ag particles were deposited only on the unexposed parts.

Subsequently, this substrate was dipped for 3 h into an electroless copper plating solution after which it was washed with water and dried at 80°C for 10 min. As a result, copper was uniformly deposited only on the previously formed Ag particle pattern, and no deposition of copper was observed on the other parts.

The above examples show that the method according to the invention is well suited for forming metallic images on substrates.

# 0 043 480



**Claims**

1. A process for forming metallic images on a substrate comprising:

— coating a solution of a photosensitive material onto a surface of the substrate,
— drying the photosensitive material,
— irradiating the dried coating of photosensitive material with ultraviolet radiation, electron beams or ion beams through a photo-mask and,
— contacting the resulting substrate with a metal salt plating solution to deposit metal particles on the unexposed portions,

characterised in that there are used;
(A) as the photosensitive material, either
(a) at least one organic compound having in the molecule at least one linkage of the formula —M—M-(-M-)$_n$, wherein M is an atom of Si, Ge or Sn, and n is zero or an integer of 1 to 10, or
(b) at least one organic compound (a) in admixture with at least one photosensitizer selected from nitrofluorene and derivatives thereof, benzophenone and derivatives thereof, acetophenone and derivatives thereof, benzil and derivatives thereof and benzoin and derivatives thereof, and
(B) as solvent for the photosensitive material halogenated hydrocarbons, aromatic hydrocarbons, heterocyclic compounds, or mixtures thereof and that when ultraviolet radiation is used to irradiate the dried coating of photosensitive material it has a wavelength of 300 nm or less in the case of A (a) and a wavelength within the whole wavelength range in the case of A (b).

2. A process according to claim 1, characterised in that the organic compound defined under (A) (a) is 1,2-dimethyldisilane, 1,1,1-trichlorotrimethyldisilane, penta-methyldisilanyl cyanide, hexaphenyldisilane, ethoxypentamethyldisilane, octamethyl-1,4-dioxa-2,3,5,6-tetrasilacyclohexane, bis(pentamethyl-disilanyl)ether, tetramethyl-1,2-bis(pentamethyldisilanoxy)disilane, 1,1'-bis(pentamethyldisilanyl)ferro-cene, bis(pentaethyldisilanyl)mercury, 1,2,2,3-tetramethyltetraphenyltrisilane, octaphenyltrisilane, octamethyl-1,4-diphenyltetrasilane, tris(dimethylphenylsilyl)silane, octamethyl-2,2,4,4-tetraphenylpentasilane, 1,5-bis(allyloxy)decaphenylpentasilane, 1,6-dichlorododecamethylhexasilane, 1,1-dimethyldecaphenyl-cyclohexasilane, hexadecamethylheptasilane, dodecamethyl-1,1,1,8,8,8-hexaphenyloctasilane, dodecamethyl-1,1,1,2,2,9,9,10,10,10-decaphenyldecasilane, tetrabromo-1,2-diphenyldigermane, 1,2-diethyltetra-phenyldigermane, hexaphenyldigermane, octaphenyltrigermane, tris(triphenylgermyl)germane, decaphenylcyclopentagermane, 1,2-dichlorotetramethylditin, 1,1,1-trimethyltriphenylditin, 1,2-bis(trichloroacetoxy)tetraphenylditin, hexaphenylditin, hexa-2-biphenylditin, 1,3-dichlorohexa-n-propyltritin, 1,4-dichlorooctaethyltetratin, octa-tert-butyl-cyclotetratin, octabenzylcyclotetratin, tetrakis(triphenylstannyl)tin, dodecaphenylcyclohexatin or dodeca-β-naphthylcyclohexatin.

3. A process according to claim 1 or 2, characterised in that the photosensitizer defined under (A) (b) in claim 1 is 2-nitrofluorene, 2,4,7-trinitrofluorene, 2,4,5,7-tetranitrofluorene, benzophenone, 4-methoxybenzophenone, 4,4'-dimethoxybenzophenone, 3-methoxybenzophenone, 4,4'-dibromobenzophenone, 4,4'-dichlorobenzophenone, 3-chlorobenzophenone, 4-cyanobenzophenone, 2,4-dimethylbenzophenone, 4-phenylbenzophenone, 4,4'-bis(dimethylamino)benzophenone, acetophenone, 3-cyanoacetophenone, 4-methylacetophenone, 3-bromoacetophenone, 2,4,6-trimethylacetophenone, 4-chloroacetophenone, 4-methoxyacetophenone, 4-phenylacetophenone, benzil, 4,4'-dimethoxybenzil, 4,4'-dibromobenzil, benzoin, benzoin methyl ether, benzoin ethyl ether, benzoin isopropyl ether or benzoin acetate.

4. A process according to one of claims 1 to 3, characterised in that 1,2-dichloroethane, 1,1,2-trichloroethane or carbon tetrachloride are used as solvent for the photosensitive material.

5. A process according to one of claims 1 to 4, characterised in that ultraviolet radiation having a wavelength of 300—50 nm is used in the case (A) (a) of claim 1.

6. A process according to one of claims 1 to 4, characterised in that ultraviolet radiation having a wavelength of 320—500 nm is used in the case (A) (b) of claim 1.

**Revendications**

1. Procédé de formation d'images métalliques sur un substrat incluant:

— le recouvrement d'une surface du substrat par une solution de substance photosensible,
— le séchage de la substance photosensible,
— l'irradiation du revêtement sec de la substance photosensible par un rayonnement ultraviolet, des faisceaux d'électrons ou des faisceaux d'ions moyennant l'interposition d'un photomasque, et
— la mise en contact du substrat obtenu, avec une solution de placage d'un sel métallique pour déposer les particules de métal sur les parties non exposées,

caractérisé en ce que l'on utilise
(A) comme substance photosensible,
(a) soit au moins un composé organique comportant dans sa molécule au moins une liaison de

8

# 0 043 480

formule M—M—(M—)$_n$ dans laquelle M est un atome de Si, de Ge ou Sn, et n est nul ou un nombre entier compris entre 1 et 10,

(b) soit au moins un composé organique (a) en mélange avec au moins un photosensibilisateur choisi parmi le nitrofluorène et ses dérivés, la benzophénone et ses dérivés, l'acétophénone et ses dérivés, le benzile et ses dérivés et la benzoïne et ses dérivés, et

(B) comme solvant pour la substance photosensible, des hydrocarbures halogénés, des hydrocarbures aromatiques, des composés hétérocycliques ou des mélanges de ces éléments et que, lorsque l'on utilise le rayonnement ultraviolet pour irradier le revêtement sec de la substance photosensible, il possède une longueur d'onde de 300 nm ou moins dans le cas de A (a) et un longueur d'onde située dans l'ensemble de la plage des longueurs d'onde dans le cas de A(b).

2. Procédé selon la revendication 1, caractérisé en ce que le composé organique défini en (A)(a) est du 1,2-diméthyldisilane, 1,1,1-trichlorotrimethyldisilane, pentaméthyldisilanyl cyanure, hexaphényldisilane, éthoxypentaméthyldisilane, octaméthyl-2,4-dioxa-2,3,5,6-tétrasilacyclohexane, bis(pentaméthyldisilanyl)-éther, tétraméthyl-1,2-bis(pentaméthyldisilanoxy)disilane, 1,1'-bis(pentaméthyldisilanyl)ferro-cène, bis(pentaéthyldisilanyl)mercure, 1,2,2,3-tétraméthyl-tétraphényltrisilane, octaphényltrisilane, octa-méthyl-1,4-diphényltetrasilane, tris(diméthylphénylsilyl)-silane, octaméthyl-2,2,4,4-tétraphénylpenta-silane, 1,5-bis(allyloxy)décaphénylpentasilane, 1,6-dichlorododecaméthylhexasilane, 1,1-diméthyl-decaphénylcyclohexasilane, hexadecaméthylheptasilane, dodecamethyl 1,1,1,8,8,8-hexaphényloctasilane, dodecamethyl-1,1,1,8,8,8-hexaphenyloctasilane, dodecamethyl-1,1,1,2,2,9,9,10,10,10-décaphényl-decasilane, tetrabromo-1,2-diphenyldigermane, 1,2-diéthyltétraphényldigermane, hexaphényldigermane, octaphényltrigermane, tris(triphénylgermyl)germane, décaphénylcyclopentagermane, 1,2-dichlorotetra-methylditine, 1,1,1-trimethyltriphenylditine, 1,2-bis(trichloroacétoxy)tetraphénylditine, hexaphénylditine, hexa-2-biphénylditine, 1,3-dichlorohexa-n-propyltritine, 1,4-dichlorooctaéthyltétratine, octa-tert-butyl-cyclotétratine, octabenzylcyclotétratine, tétrakis(triphenylstannyl)tine, dodecaphénylcyclohexatine ou dodéca-β-naphthylcyclohexatine.

3. Procédé selon la revendication 1 ou 2, caractérisé en ce que le photosensibilisateur défini en (A)(b) dans la revendication 1 est du: 2-nitrofluorène, 2,4,7-trinitrofluorène, 2,4,4,7-tétranitrofluorène, benzophénone, 4-méthoxybenzophénone, 4,4'-diméthoxybenzophénone, 3-méthoxybenzophénone, 4,4'-dibromobenzophénone, 4,4'-dichlorobenzophénone, 3-chlorobenzophénone, 4-cyanobenzophénone, 2,4-diméthylbenzophénone, 4-phénylbenzophénone, 4,4'-bis(diméthylamino)-benzophénone, acéto-phénone, 3-cyanoacétophénone, 4-méthylacétophénone, 3-bromoacétophénone, 2,4,6-trimethylacéto-phénone, 4-chloroacétophénone, 4-méthoxyacétophénone, 4-phénylacétophénone, benzile, 4,4'-diméthoxybenzile, 4,4'-dibromobenzile, benzoïne, méthyl éther de benzoïne, éther éthyl de benzoïne, éther isopropylique de benzoïne ou acétate de benzoïne.

4. Procédé selon l'une des revendications 1 à 3, caractérisé en ce que l'on utilise du 1,2-dichloroéthane, du 1,1,2-trichloroéthane ou du tétrachlorure de carbone en tant que solvant pour la substance photosensible.

5. Procédé selon l'une des revendications 1 à 4, caractérisé en ce que l'on utilise un rayonnement ultraviolet possédant une longueur d'onde de 300—50 nm dans le cas (A)(a) de la revendication 1.

6. Procédé selon l'une des revendications 1 à 4, caractérisé en ce que l'on utilise un rayonnement ultraviolet possédant une longueur d'onde 320—500 nm dans le cas (A)(b) de la revendication 1.

**Patentansprüche**

1. Verfahren zur Erzeugung metallischer Bildmuster auf einem Schichtträger, bei welchem

— eine Oberfläche des Schichtträgers mit einer Lösung eines lichtempfindlichen Materials überzogen wird,
— das lichtempfindliche Material getrocknet wird,
— die getrocknete Schicht aus lichtempfindlichem Material mit UV-, Elektronen- oder Ionenstrahlen durch eine Photomaske bestrahlt wird, und
— der so erhaltene Schichtträger mit einer Metallsalz-Überzugslösung in Berührung gebracht wird zur Ablagerung von Metallteilchen auf den nichtbestrahlten Flächenbereichen,

dadurch gekennzeichnet, dass
(A) als lichtempfindliches Material entweder
(a) wenigstens eine organische Verbindung mit zumindest einem Bindeglied der Formel —M—M—(M—)$_n$ im Molekül, wobei M ein Si-, Ge- oder Sn-Atom ist, oder
(b) wenigstens eine organische Verbindung (a) in Mischung mit zumindest einem Photosensibilisator aus der Gruppe Nitrofluoren, Acetophenon, Benzil, Benzoin und Derivate der genannten Verbindungen verwendet wird und
(B) als Lösungsmittel für das lichtempfindliche Material halogenierte Kohlenwasserstoffe, aromatische Kohlenwasserstoffe, heterozyklische Verbindungen oder Mischungen derselben verwendet werden und dass bei Verwendung von UV-Strahlung zur Ionisierung der getrockneten Schicht aus lichtempfindlichem

9

Material die Strahlung eine Wellenlänge von 300 nm oder darunter im Falle von A(a) und eine Wellenlänge innerhalb des gesamten Wellenlängenbereichs im Falle von A(b) hat.

2. Verfahren nach Anspruch 1, dadurch gekennzeichnet, dass die in Punkt A(a) definierte organische Verbindung 1,2-Dimethyldisilan, 1,1,1-Trichlortrimethyldisilan, Pentamethyldisilanylcyanid, Hexaphenyldisilan, Äthoxypentamethyldisilan, Octamethyl-1,4-dioxa-2,3,5,6-tetrasilacyclohexan, Bis(pentamethyldisilanyl)äthan, Tetramethyl-1,2-bis(pentamethyldisilanoxy)disilan, 1,1'-Bis-(pentamethyldisilanyl)ferrocen, Bis(pentaäthyldisilanyl)quecksilber, 1,2,2,3-Tetramethyltetraphenyltrisilan, Octaphenyltrisilan, Octamethyl-1,4-diphenyltetrasilan, Tris(dimethylphenylsilyl)silan, Octamethyl-2,2,4,4-tetraphenylpentasilan, 1,5-bis(allyloxy)decaphenylpentasilan, 1,6-Dichlordodecamethylhexasilan, 1,1-Dimethyldecaphenylcyclohexasilan, Hexadecamethylheptasilan, Dodecamethyl-1,1,1,8,8,8-hexaphenyloctasilan, Dodecamethyl-1,1,1,8,8,8-hexaphenyloctasilan, Dodecamethyl-1,1,1,2,2,9,9,10,10,10-decaphenyldecasilan, Tetrabrom-1,2-diphenyldigerman, 1,2-Diäthyltetraphenyldigerman, Hexaphenyldigerman, Octaphenyltrigerman, Tris-(triphenylgermyl)german Decaphenylcyclopentagerman, 1,2-Dichlortetramethyldistannan, 1,1,1-Trimethyltriphenyldistannan, 1,2-Bis(trichloracetoxy)tetraphenyldistannan, Hexaphenyldistannan, Hexa-2-biphenyldistannan, 1,3-Dichlorhexa-n-propyltristannan, 1,4-Dichloroctaäthyltetrastannan, Octa-tert.-butylcyclotetrastannan, Octabenzylcyclotetrastannan, Tetrakis(triphenylstannyl)stannan, Dodecaphenylcyclohexastannan oder Dodeca-β-naphthylcyclohexastannan ist.

3. Verfahren nach Anspruch 1 oder 2, dadurch gekennzeichnet, dass der unter A(b) in Anspruch 1 definierte Photosensibilisator 2-Nitrofluoren, 2,4,7-Trinitrofluoren, 2,4,5,7-Tetranitrofluoren, Benzophenon, 4-Methoxybenzophenon, 4,4'-Dimethoxybenzophenon, 3-Methoxybenzophenon, 4,4'-Dibrombenzophenon, 4,4'-Dichlorbenzophenon, 3-Chlorbenzophenon, 4-Cyanbenzophenon, 2,4-Dimethylbenzophenon, 4-Phenylbenzophenon, 4,4'-Bis(dimethylamino)benzophenon, Acetophenon, 3-Cyanacetophenon, 4-Methylacetophenon, 3-Bromacetophenon, 2,4,6-Trimethylacetophenon, 4-Chloracetophenon, 4-Methoxyacetophenon, 4-Phenylacetophenon, Benzil, 4,4'-Dimethoxybenzil, 4,4'-Dibrombenzil, Benzoin, Benzoinmethyläther, Benzoinäthyläther, Benzoinisopropyläther oder Benzoinacetat ist.

4. Verfahren nach Anspruch 1 oder 2, dadurch gekennzeichnet, dass 1,2-Dichloräthen, 1,1,2-Trichloräthen oder Tetrachlorkohlenstoff als Lösungsmittel für das lichtempfindliche Material verwendet wird.

5. Verfahren nach einem der Ansprüche 1 bis 4, dadurch gekennzeichnet, dass UV-Strahlung einer Wellenlänge von 50 bis 300 nm bei der Ausführungsform A(a) von Anspruch 1 verwendet wird.

6. Verfahren nach einem der Ansprüche 1 bis 4, dadurch gekennzeichnet, dass UV-Strahlung einer Wellenlänge von 320 bis 500 nm bei der Ausführungsform A(b) von Anspruch 1 verwendet wird.